## Europäisches Patentamt

## European Patent Office

## Office européen des brevets

(19)

(11) Veröffentlichungsnummer: **0 252 272**
**B1**

(12) **EUROPÄISCHE PATENTSCHRIFT**

(45) Veröffentlichungstag der Patentschrift:
22.08.90

(51) Int. Cl.⁵: **H03J 1/04**

(21) Anmeldenummer: **87107798.8**

(22) Anmeldetag: **29.05.87**

(54) Hochfrequenzempfänger mit einer digitalen Anzeige der Emfangsfrequenz.

(30) Priorität: **04.06.86 DE 3618782**

(43) Veröffentlichungstag der Anmeldung:
**13.01.88 Patentblatt 88/2**

(45) Bekanntmachung des Hinweises auf die Patenterteilung:
**22.08.90 Patentblatt 90/34**

(84) Benannte Vertragsstaaten:
**AT CH DE FR GB IT LI**

(56) Entgegenhaltungen:
WO-A-82/01968
DE-A- 1 466 222
DE-A- 2 933 416
FR-A- 2 420 247
GB-A- 2 019 144

(73) Patentinhaber: **Blaupunkt-Werke GmbH,
Robert-Bosch-Strasse 200, D-3200 Hildesheim(DE)**

(72) Erfinder: **Suppa, Karl-Heinz, An den Vier Linden 21,
D-3200 Hildesheim(DE)**

(74) Vertreter: **Eilers, Norbert, Dipl.-Phys., Blaupunkt-Werke
GmbH Robert-Bosch-Strasse 200,
D-3200 Hildesheim(DE)**

## Beschreibung

Die Erfindung betrifft ein Autoradio gemäß dem Oberbegriff des Anspruchs 1.

Zur Verbesserung des Bedienungskomforts werden bekanntlich insbesondere Autoradios in zunehmendem Maße mit einer digitalen Frequenzanzeige ausgestattet. Gegenüber der herkömmlichen analogen Senderanzeige auf einer Skala gibt die digitale Frequenzanzeige dem Benutzer exakt den Zahlenwert der Empfangsfrequenz und somit auch den jeweils gehörten Sender an. Dadurch wird die Abstimmung auf gewünschte Sender sowie die Erkennung empfangener Sender erheblich erleichtert.

Die optische Darstellung bzw. die Ermittlung der Empfangsfrequenz wird in der Praxis unter Zuhilfenahme der Zwischenfrequenz des Hochfrequenzempfängers und der Frequenz des Überlagerungsoszillators erreicht.

Die Empfangsfrequenz, die Zwischenfrequenz und die Oszillatorfrequenz stehen nämlich in einer festen Beziehung zueinander, die es erlaubt, die Empfangsfre quenz bei bekannter Oszillatorfrequenz und bei bekannter Zwischenfrequenz rechnerisch zu ermitteln. Da sich bei einem Hochfrequenzempfänger sowohl die Zwischenfrequenz als auch die Oszillatorfrequenz leicht feststellen lassen, wird die zur Anzeige gebrachte Empfangsfrequenz aus den voranstehend genannten beiden Frequenzwerten ermittelt und dargestellt.

Es wird also die bekannte Beziehung ausgenutzt, daß die Zwischenfrequenz die Differenz zwischen der Oszillatorfrequenz und der Eingangsfrequenz ist, d.h., bei bekannter Oszillatorfrequenz und Zwischenfrequenz läßt sich die Empfangsfrequenz rechnerisch ermitteln. Es ist daher nicht erforderlich, die tatsächlich empfangene Frequenz selbst zu messen, was übrigens nur mit sehr aufwendigen Schaltungsmaßnahmen möglich wäre.

Neben der leicht in einem Hochfrequenzempfänger meßbaren Oszillatorfrequenz setzt demnach die genaue Anzeige der Empfangsfrequenz voraus, daß der exakte und tatsächliche Wert der in dem betreffenden Hochfrequenzempfänger vorhandenen Zwischenfrequenz als konstante zu berücksichtigende Größe bekannt ist. Hierbei ergeben sich in der Praxis aber gewisse Schwierigkeiten, da die tatsächlich in einem bestimmten Hochfrequenz empfänger vorhandene Zwischenfrequenz von den vorgegebenen Werten - z.B. 10,7 MHz - abweichen kann. Solche möglichen Abweichungen sind auf die Beschaffenheit der jeweils verwendeten Keramikfilter innerhalb der Zwischenfrequenzstufe zurückzuführen.

Die bekannten Keramikfilter lassen sich nämlich nur mit einer gewissen Toleranz herstellen, d.h., der angestrebte Wert von 10,7 MHz ist nicht immer gewährleistet. Tatsächlich ergeben sich in der Praxis festzustellende Abweichungen in Schritten von 25 KHz bzw. 30 KHz, und entsprechend der jeweiligen Abweichungen werden die im Anschluß an ihre Herstellung exakt vermessenen Keramikfilter mit entsprechenden Gruppen-Codes gekennzeichnet. Üblich sind heute fünf Gruppen innerhalb eines Frequenzbereiches von 10,61 - 10,79 MHz für den FM-Bereich. Im AM-Bereich bei 450 - 465 KHz liegen die Toleranzen meist bei ± 2 KHz.

Für eine genaue digitale Anzeige der jeweiligen Empfangsfrequenz ist es daher nicht ausreichend, den theoretischen Wert der Zwischenfrequenz zu berücksichtigen, vielmehr muß der bei dem jeweiligen Hochfrequenzempfänger auf Grund der verwendeten Keramik filter tatsächlich gegebene Wert der Zwischenfrequenz berücksichtigt werden. Erschwerend kommt noch dazu, daß die heute üblichen Keramikfilter innerhalb der weiter oben genannten Abweichungen bzw. Gruppen von beispielsweise ± 30 KHz weiteren Schwankungen unterworfen sind, so daß die Kenntnis einer bestimmten Gruppe des jeweils verwendeten Keramikfilters nicht ausreicht, um die tatsächlich gegebene Zwischenfrequenz für die digitale Frequenzanzeige als konstante Größe vorzugeben.

Vielmehr ist es für eine gewünschte exakte digitale Anzeige der Empfangsfrequenz erforderlich, bei einem Hochfrequenzempfänger die auf Grund der jeweils verwendeten Keramikfilter tatsächlich vorhandene Zwischenfrequenz zu messen und den ermittelten Wert dann bei der "Berechnung" der Empfangsfrequenz zugrunde zu legen. Zu diesem Zweck wird der Hochfrequenzempfänger nach seiner Fertigung in eine Prüfbetriebsart versetzt, um die tatsächliche Zwischenfrequenz zu messen. Dabei wird an den Eingang des Hochfrequenzempfängers eine bekannte Empfangsfrequenz gelegt, und unter Berücksichtigung der ebenfalls bekannten Frequenz des Überlagerungsoszillators wird dann die tatsächliche Zwischenfrequenz ermittelt.

Dieser tatsächliche und von den jeweils verwendeten Keramikfiltern abhängige Wert der Zwischenfrequenz wird dann als eine konstante Größe berücksichtigt, um bei der Benutzung des Hochfrequenzempfängers die empfangene Frequenz zu berechnen. Um dies zu ermöglichen, ist es erforderlich, den Wert der tatsächlichen Zwischenfrequenz des jeweiligen Hochfrequenzempfängers festzuhalten bzw. den Hochfrequenzempfänger entsprechend zu programmieren.

Durch die Autoradios vom Typ "Köln SQR 22" und "Köln IQR 25" der Anmelderin ist es zur Erfüllung der voranstehend beschriebenen Forderung schon bekannt, eine Diodenmatrix vorzusehen, um die in der Prüfbetriebsart ermittelte tatsächliche Zwischenfrequenz festzuhalten. Dies geschieht in Form einer Kodierung, indem bestimmte einzelne oder auch mehrere Diodenstrecken aufgetrennt werden, so daß durch diese Diodenstrecken kein Strom fließen kann. Bei der bekannten mechanischen Lösung werden die Diodenstrecken der Diodenmatrix dann abgefragt, und aufgrund dieser Abfrage bzw. der Kodierung ist der tatsächliche Wert der Zwischenfrequenz bekannt, der dann bei der rechnerischen Ermittlung der jeweiligen Empfangsfrequenz berücksichtigt werden kann.

Mit Hilfe der Diodenmatrix ist es zwar möglich, in gewünschter Weise die Empfangsfrequenz genau anzuzeigen, allerdings besteht ein Nachteil darin, daß das Festhalten der in der Prüfbetriebsart ermittelten Zwischenfrequenz nicht zerstörungsfrei erfolgt, da bestimmte Diodenstrecken mechanisch aufgetrennt werden müssen. Im übrigen erfordert die Diodenmatrix nicht nur einen zusätzlichen Schaltungsaufwand, sondern auch einen Platzbedarf und ist häufig nur sehr schwer zugänglich.

Ein weiterer Nachteil besteht darin, daß eine bei Reparaturarbeiten eventuell erforderliche Kodierung bzw. Programmierung der Zwischenfrequenz nur mit erheblichen Zeitaufwand und unter schwierigen Bedingungen durch führbar ist. Die Notwendigkeit einer neuen Programmierung ergibt sich beispielsweise dann, wenn im Zwischenfrequenzteil die Keramikfilter ausgetauscht werden.

Bei einer neuen Programmierung ist es unter Umständen erforderlich, zuvor unterbrochene Diodenstrecken wieder zu verlöten, um eine elektrische Verbindung herzustellen. Dabei besteht die Gefahr der Zerstörung der Dioden. Um andere leitende Diodenstrecken zu un terbrechen, müssen Drahtverbindungen mit einer Zange oder dergleichen aufgetrennt werden, was sich schwierig gestaltet, wenn die Diodenmatrix örtlich schwer zugänglich ist.

Der Erfindung liegt die Aufgabe zugrunde, zur Beseitigung der beschriebenen Nachteile eine einfache Möglichkeit der Programmierung der Zwischenfrequenz zu schaffen, die auch bei notwendigen Reparaturarbeiten mit einfachen Mitteln eine neue Programmierung der Zwischenfrequenz erlaubt, ohne daß damit ein zusätzlicher Schaltungsaufwand verbunden ist.

Dieses Ziel erreicht die Erfindung bei dem im Oberbegriff des Anspruchs 1 vorausgesetzten Autoradio dadurch, daß in einem Prüfbetrieb des Autoradios der extern gemessene Wert der Zwischenfrequenz mittels der Bedienelemente des Autoradios in einen nicht flüchtigen elektronischen Speicher eingebbar ist.

Anstelle der bisher verwendeten mechanischen Programmierung sieht die Erfindung also die Verwendung eines elektronischen Speichers vor. Diese Maßnahme führt zu mehreren Vorteilen. So ist hervorzuheben, daß die Programmierung der Zwischenfrequenz im Gegensatz zu der bekannten Lösung zerstörungsfrei durchgeführt werden kann und erheblich einfacher als die mechanische Programmierung ist. Ebenso läßt sich der gespeicherte Wert bzw. eine neue Programmierung bei Reparaturarbeiten leicht ändern. Im Vergleich zu einer Diodenmatrix ist schließlich der zusätzliche Bauteileaufwand vernachlässigbar, da lediglich ein zusätzlicher elektronischer Speicher benötigt wird und keine zusätzlichen Leitungen erforderlich sind. Im übrigen befinden sich bei Hochfrequenzempfängern häufig schon elektronische Speicher im Einsatz, die dann im Sinne der Erfindung mit ausgenutzt werden können.

Für die eigentliche Programmierung des elektronischen Speicher lassen sich gemäß der Erfindung die schon vorhandenen Bedienelemente des Autoradios verwenden, das zu diesem Zweck in eine Prüfbetriebsart umschaltbar ist.

Eine weitere zweckmäßige Ausgestaltung der Erfindung ist Gegenstand des Unteranspruchs und der Zeichnung zu entnehmen.

Nachfolgend wird die Erfindung zum besseren Verständnis anhand des in der Zeichnung dargestellten Ausführungsbeispiels näher erläutert. Es zeigen:

Fig. 1 ein Blockschaltbild der wesentlichen Teile eines Hochfrequenzempfängers in der Prüfbetriebsart zur Ermittlung und Speicherung der Zwischenfrequenz, und

Fig. 2 ein Flußdiagramm zur Erläuterung der Programmierung der Zwischenfrequenz in einem elektronischen Speicher.

Der in teilweiser Darstellung als Blockschaltbild gezeigte Hochfrequenzempfänger umfaßt eine HF-Vorstufe 10, an den sich eine Mischstufe 12 anschließt. Auf die Mischstufe 12 folgt eine ZF-Stufe 16 mit hier nicht näher dargestellten Keramikfiltern. Die weiteren Stufen für die Demodulation und Erzeugung der Niederfrequenz NF sind hier nicht weiter von Bedeutung und daher auch nicht dargestellt.

Zur Erzeugung der Zwischenfrequenz ZF umfaßt der Hochfrequenzempfänger in an sich bekannter Weise eine PLL-Stufe 18 sowie einen mit der Mischstufe 12 verbundenen Oszillator 14. Die PLL-Stufe 18 wird von einem Mikroprozessor 20 angesteuert, der in an sich bekannter Weise unter anderem einen RAM-Speicher und ROM-Speicher besitzt. Außerdem steht der Mikroprozessor 20 in Verbindung mit einer LCD-Anzeige 26 für die Empfangsfrequenz und mit den Bedienelementen 22 (Tasten für die Bereichswahl usw.) des Hochfrequenzempfängers.

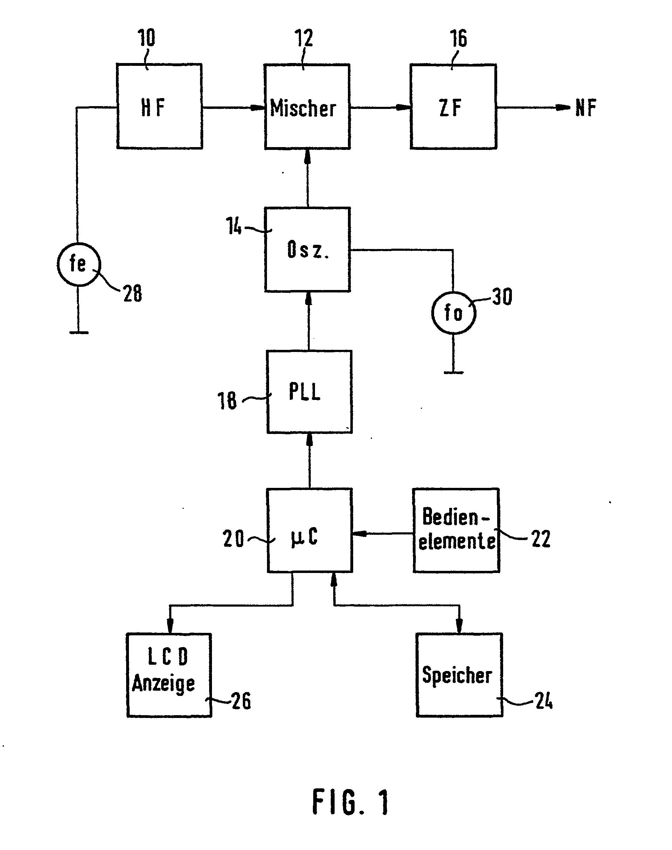

Zur Ermittlung der tatsächlichen Zwischenfrequenz ist der Hochfrequenzempfänger durch Betätigung von Bedienelementen oder auch eines gesonderten Schalters in eine Prüfbetriebsart umschaltbar, die in Fig. 1 dargestellt ist. In der Prüfbetriebsart wird die HF-Vorstufe 10 von einem Meßsender 28 mit der Frequenz $f_e$ gespeist, und außerdem wird mit einem Frequenzmesser 30 die Frequenz $f_o$ des Oszillators 14 gemessen. Aus den beiden Frequenzwerten $f_e$ und $f_o$ ergibt sich die aufgrund der verwendeten Keramikfilter tatsächlich einstellende Zwischenfrequenz, und der Wert dieser Zwischenfrequenz wird in einem nichtflüchtigen Speicher (EEPROM; oder PROM, oder EPROM) 24 durch eine entsprechende Programmierung gespeichert.

Die Programmierung erfolgt mit Hilfe der Bedienelemente 22 des Hochfrequenzempfängers, wobei mit den Stationstasten die einzelnen Stellen des einzugebenen Zahlenwertes selektiert werden. Für die Unterscheidung, ob die Zwischenfrequenz im FM-Bereich oder im AM-Bereich eingegeben wird, kann zuvor die UKW-Bereichstaste bzw. die MW-Bereichstaste dienen.

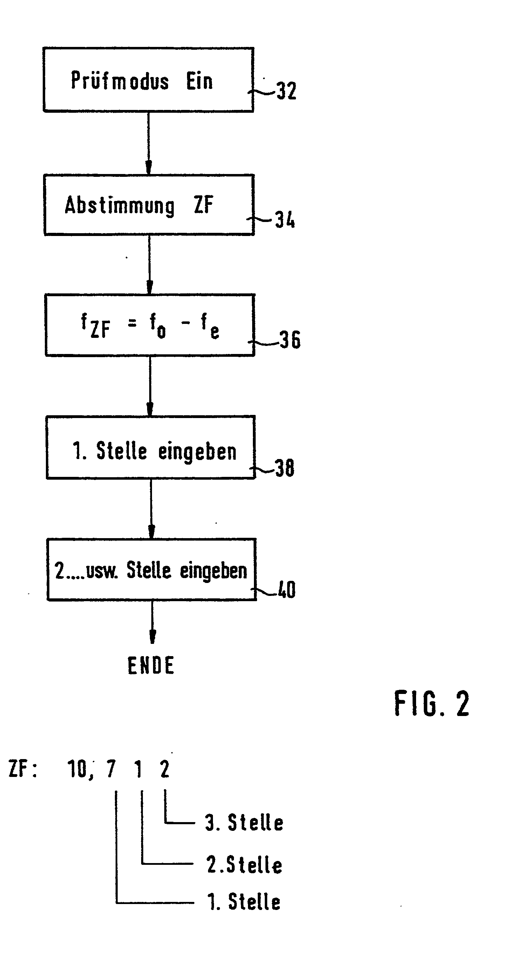

Anhand von Fig. 2 wird nachfolgend die Programmierung der sich aus der Differenz der Oszillatorfrequenz $f_o$ und der Eingangsfrequenz $f_e$ ergebende Zwischenfrequenz erläutert. Zur genauen Ermittlung der Zwischenfrequenz wird dabei auf ein spezielles Kriterium abgestimmt (z.B. Klirrfaktorminimierung; minimale Ausgangsspannung bei Mittelwelle für eine Modulationsfrequenz von 5 KHz, usw.).

Der Block 32 in Fig. 2 verdeutlicht, daß durch gleichzeitiges Drücken von beispielsweise 3 Bedienelementen der Prüfmodus bzw. die Prüfbetriebsart eingeschaltet wird. Danach erfolgt (vgl. Block 34) die Abstimmung des Hochfrequenzgerätes nach einem der oben genannten gewählten Kriterien, und der Block 36 gibt an, daß die Zwischenfrequenz $f_{ZF}$ aus der Differenz der Oszillatorfrequenz $f_0$ und der Frequenz des Meßsenders $f_e$ ermittelt wird (dies gilt für den Fall, daß die Oszillatorfrequenz $f_0$ größer als die Empfangsfrequenz $f_e$ ist).

Es sei angenommen, daß der ermittelte Zahlenwert der Zwischenfrequenz 10,712 MHz beträgt. Da die möglichen Abweichungen so gering sind, daß die ersten beiden Ziffern "1" und "0" sich nicht ändern, genügt es, die danach folgenden Ziffern einzugeben und den Wert "10" vorher fest zu speichern.

Im angenommenen Fall werden jetzt über die Bedienelemente nacheinander die erste Stelle "7", die zweite Stelle "1" und die dritte Stelle "2" über die Bedienelemente 22 eingegeben, wie dies durch die Blöcke 38, 40 verdeutlicht wird. Zur Kontrolle können die jeweils eingegebenen Ziffern auf der LCD-Anzeige 26 dargestellt werden.

Am Ende der Programmierung ist der Zwischenfrequenzwert 10,712 MHz in dem elektronischen Speicher 24 abgespeichert, und mit Hilfe des Mikroprozessors 20 wird der tatsächliche Wert der Zwischenfrequenz bei der Anzeige der Empfangsfrequenz berücksichtigt.

Der Vollständigkeit halber ist darauf hinzuweisen, daß die Abstimmung bei einem Autoradio im UKW-Bereich in Rasterschritten von 10 KHz oder auch von 12,5 KHz erfolgen kann. Bei Rasterschritten von 12,5 KHz ergeben sich beispielsweise Werte von 10,700 - 10,7125 - 10,725... MHz. In solchen Fällen muß deshalb der gemessene tatsächliche Wert der Zwischenfrequenz $f_{ZF}$ auf- oder abgerundet werden. Hierfür sind in dem neuen Hochfrequenzempfänger zwei Möglichkeiten denkbar.

Es sei angenommen, daß die Rasterschritte 12,5 KHz betragen und daß der tatsächliche Wert der Zwischenfrequenz $f_{ZF}$ 10.712 MHz beträgt. Deshalb müßte der Wert 10,7125 eingegeben werden, wobei die letzte Ziffer "5" wegen der Eindeutigkeit weggelassen werden kann.

Es ist aber auch eine "komfortable" Software möglich, die selbst auf- oder abrundet. Bei dem Wert 10.712 würde dann der Wert 10.7125 angenommen werden. Ein weiteres Beispiel: der tatsächliche Ist-Wert beträgt 10.705, und dieser Wert wird auf 10,700 abgerundet und der Mikroprozessor 20 arbeitet mit 10,700 MHz.

Die beschriebenen Möglichkeiten sind sinnvoll, weil die vorhandenen UKW-Sender auch innerhalb der Rasterschritte liegen. So betragen die Abstände zwischen den einzelnen UKW-Sendern 100 KHz (8 x 12,5 KHz). Vereinzelt sind auch Abstände bzw. Zwischenwerte auf 50 KHz und 75 KHz anzutreffen.

## Patentansprüche

1. Autoradio mit digitaler Anzeige der Empfangsfrequenz, die aus der Zwischenfrequenz und der Frequenz des Überlagerungs-Oszillators ermittelt wird, wobei der nach Eingabe einer bekannten Trägerfrequenz einmalig gemessene Wert der Zwischenfrequenz bei der Ermittlung der anzuzeigenden Empfangsfrequenz als konstante Größe an einem pinprogrammierten Baustein abfragbar ist, dadurch gekennzeichnet, daß in einem Prüfbetrieb des Autoradios der extern gemessene Wert der Zwischenfrequenz mittels der Bedienelemente des Autoradios in einen nicht flüchtigen elektronischen Speicher (24) eingebbar ist.

2. Autoradio nach Anspruch 1, dadurch gekennzeichnet, daß die Programmierung des Speichers (24) mit den jeweils in den unterschiedlichen Empfangsbereichen gemessenen Zwischenfrequenzen durch Betätigen der Bedienelemente für die Bereichswahl des Autoradios eingeleitet wird und durch die Betätigung der Stationstasten vollendet wird.

## Claims

1. Car radio with digital display of the receive frequency, which is calculated from the intermediate frequency and the frequency of the heterodyne oscillator, it being possible when calculating the receive frequency to be displayed, after input of a known carrier frequency, to interrogate at a pin-programmed module the value of the intermediate frequency, measured once, as a constant value, characterized in that, in a test mode of the car radio, the externally measured value of the intermediate frequency can be entered in a non-volatile electronic memory (24) by means of the operating elements of the car radio.

2. Car radio according to Claim 1, characterized in that the programming of the memory (24) with the intermediate frequencies measured in each case in the various receiving ranges is initiated by pressing the operating elements for the range selection of the car radio, and is completed by pressing the station keys.

## Revendications

1. Auto-radio avec indication (affichage) numérique de la fréquence de réception déterminée à partir de la fréquence intermédiaire et de la fréquence de l'oscillateur de combinaison, et la grandeur mesurée une fois de la fréquence de la porteuse, connue après son introduction, correspondant à la fréquence intermédiaire est susceptible d'être demandée lorsqu'on détermine la fréquence de réception affichée comme grandeur constante sur un composant programmable, auto-radio caractérisé en ce que dans un poste d'essai de l'auto-radio, on détermine la valeur mesurée de manière externe de la fréquence intermédiaire à l'aide des éléments de commande de l'auto-radio et on introduit cette grandeur dans une mémoire électronique non fugitive (24).

2. Auto-radio selon la revendication 1, caractérisé en ce que la programmation de la mémoire (24) à l'aide des fréquences intermédiaires, respectives, mesurées dans les différentes plages de réception, se termine en actionnant les éléments de manœuvre pour la sélection de la plage de l'autoradio et on détermine en actionnant les touches des stations.

FIG. 1

**FIG. 2**